# EUROPEAN PATENT SPECIFICATION

(11) **EP 3 032 544 B1**
(45) Date of publication and mention of the grant of the patent: **27.12.2017**
(21) Application number: 15192043.6
(22) Date of filing: 29.10.2015
(51) Int. Cl.: H01B 1/22, H01L 31/0224, C09D 5/24

(54) **A CONDUCTIVE PASTE CONTAINING LEAD-FREE GLASS FRIT**
LEITFÄHIGE PASTE MIT BLEIFREIER GLASFRITTE
PÂTE CONDUCTRICE CONTENANT DE LA FRITTE DE VERRE SANS PLOMB

(30) Priority: 08.12.2014 TW 103142669
(43) Date of publication of application: 15.06.2016
(73) Proprietor: Giga Solar Materials Corp., Hsinchu (TW)
(72) Inventor: YEH, Chih-Hsien, Hsinchu (TW); SHIH, Po-Yang, Hsinchu (TW); HSIN, Pi-Yu, Hsinchu (TW)
(74) Representative: Viering, Jentschura & Partner mbB Patent- und Rechtsanwälte

(56) References cited:
- EP-A1- 2 749 545
- WO-A1-2012/158905
- WO-A1-2014/050703
- WO-A1-2014/126293
- WO-A1-2014/157958

## Description

### BACKGROUND OF THE INVENTION

### Field of the Invention

The present invention relates to a conductive paste comprising a conductive metal, a lead-free glass frit and an organic vehicle, and articles having said conductive paste applied thereto.

### Description of related art

Conventional solar cells or photovoltaic cells comprise a semiconductor substrate, a diffusion layer, an antireflective coating, a back electrode and a front electrode. The antireflective coating is used to promote the light absorption, thereby increasing the cell's efficiency; and typically comprises silicon (e.g., silicon nitride or silicon dioxide). However, said anti-reflective coatings would increase electrical resistance between the semiconductor substrate and the front electrode, and result in insulation, which impair the flow of excited state electrons.

In view of the above, when forming the front electrode, generally a conductive paste prepared by mixing a conductive metal (such as silver particles), glass (such as lead oxide-containing glass) and an organic vehicle, etc. is employed because the glass has low melting point, low melt viscosity and stability against uncontrollable de-vitrification. The conductive paste can be printed as grid lines or other patterns on the semiconductor substrate by screen printing, stencil printing or the like, followed by fire-through. During firing, the conductive paste penetrates through the antireflective coating and forms electrical contact between the semiconductor substrate and the grid line or other patterns through metal contact. The front electrode is thus produced.

To achieve proper fire-through, glasses having good solubility for the antireflective coating are preferably used as the glass frit in conductive pastes. In conventional conductive pastes for forming front electrodes, glass frits often comprise lead oxide-containing glass because the glass eases the adjustment of softening point and provides relatively good adhesiveness for substrates, allows for relatively good fire-through and results in superior solar cell characteristics.

However, increased environmental awareness in recent years has led to a desire for a switchover to lead-free materials for automotive, electronics and solar cell industries, etc. On the other hand, after firing, the ability to penetrate the antireflective coating and form a good bond to the substrate as well as the excellent conversion efficiency of solar cells should take the factors including the composition of the conductive paste and the quality of the electrical contact made between the fired-through conductive paste and the semiconductor substrate into consideration.

Lead-free conductive pastes have been disclosed in WO2014050703 A1, EP 2 749 545 A1, WO 2014/157958 A1, WO 2014/126293 A1, and WO 2012/158905 A1.

However, there is still a need to provide a conductive paste comprising lead-free glass frit which can be fired at a lower temperature and has the properties of the abovementioned conventional lead-containing materials.

### BRIEF SUMMARY OF THE INVENTION

Present invention is to provide a conductive paste containing lead-free glass frit capable of being fired at a lower temperature and to provide a lead-free article comprising said conductive paste and having good substrate adhesiveness and excellent conversion efficiency after fire-through, thereby achieving the object of providing environmentally friendly materials for conductive pastes.

To achieve the above object, one aspect of the present invention is to provide a conductive paste comprising:
(a) 85% to 99.5% by weight of a conductive metal, based on the weight of solids;
(b) 0.5% to 15% by weight of a lead-free glass frit containing tellurium-bismuth-selenium-lithium-oxide, based on the weight of solids; and
(c) an organic vehicle; wherein the weight of solids is the total weight of the conductive metal (a) and the lead-free glass frit (b), and wherein the tellurium oxide is present in an amount of 55 wt.% to 90 wt.%, the selenium oxide is present in an amount of 0.1 wt.% to 15 wt.% in the lead-free glass frit, the bismuth oxide is present in an amount of 0.1 wt.% to 15 wt.%, and the lithium oxide is present in an amount of 0.1 wt.% to 15 wt.% in the lead-free glass frit..

### DETAILED DESCRIPTION OF THE INVENTION

In one preferred embodiment of the present invention, the conductive metal includes silver powder.

In one embodiment of the present invention, the organic vehicle is a solution comprising a polymer and a solvent.

In a further preferred embodiment of the present invention, the lead-free glass frit comprises one or more elements selected from the group consisting of phosphorus (P), barium (Ba), sodium (Na), magnesium (Mg), zinc (Zn), calcium (Ca), strontium (Sr), tungsten (W), aluminum (Al), potassium (K), zirconium (Zr), vanadium (V), iron (Fe), indium (In), manganese (Mn), tin (Sn), nickel (Ni), antimony (Sb), silver (Ag), silicon (Si), erbium (Er), germanium (Ge), titanium (Ti), gallium (Ga), cerium (Ce), niobium (Nb), samarium (Sm) and lanthanum (La) or the like or the oxide thereof in an amount of 0.1% to 10 % by weight of the lead-free glass frit. In another embodiment of the present invention, the organic vehicle comprises one or more functional additives, such as viscosity modifiers, dispersing agents, thixotropic agents, wetting agents, etc.

Another aspect of the present invention is to provide an article comprising a semiconductor substrate and an abovementioned conductive paste applied on the semiconductor substrate. In one embodiment of the present invention, the article is a semiconductor device. In another embodiment of the present invention, the semiconductor device is a solar cell.

The foregoing has outlined the technical features and the technical effects of the present invention. Illustrative embodiments are described below to allow for full understanding of the present invention. The present invention may also be put into practiced by embodiments in other forms.

The conductive paste of the present invention comprising a lead-free glass frit can be applied in various industries, preferably in a semiconductor industry, more preferably in a solar cell industry. The abovementioned conductive paste comprises: (a) a conductive metal, (b) a lead-free glass frit containing tellurium-bismuth-selenium-lithium-oxide and (c) an organic vehicle; wherein the inorganic components including the conductive metal (a) and the lead-free glass frit (b) are uniformly dispersed in the organic vehicle (c).

In the present invention, the organic vehicle is not a part of solid components. Hence, the weight of solids refers to the total weight of the solid components including the conductive metal (a) and the lead-free glass frit (b), etc.

The conductive metal of the present invention is not subject to any special limitation as long as it does not have an adverse effect on the technical effect of the present invention. The conductive metal can be one single element selected from the group consisting of silver, aluminum and copper; and also can be alloys or mixtures of metals, such as gold, platinum, palladium, nickel and the like. From the viewpoint of conductivity, pure silver is preferable.

In the case of using silver as the conductive metal, it can be in the form of silver metal, silver derivatives and/or the mixture thereof. Examples of silver derivatives include silver oxide (Ag₂O), silver salts (such as silver chloride (AgCl), silver nitrate (AgNO₃), silver acetate (AgOOCCH₃), silver trifluoroacetate (AgOOCCF₃) or silver phosphate (Ag₃PO₄), silver-coated composites having a silver layer coated on the surface or silver-based alloys or the like.

The conductive metal can be in the form of powder (for example, spherical shape, flakes, irregular form and/or the mixture thereof) or colloidal suspension or the like. The average particle size of the conductive metal is not subject to any particular limitation, while 0.1 to 10 microns is preferable. Mixtures of conductive metals having different average particle sizes, particle size distributions or shapes, etc. can also be employed.

In one preferred embodiment of the present invention, the conductive metal or the derivative thereof comprises 85% to 99.5% by weight of the solid components of the conductive paste.

The lead-free glass frit of the present invention substantially does not contain the lead component. Specifically, the glass frit is substantially free of any lead and the derivatives thereof (for example, lead oxides, such as lead monoxide (PbO), lead dioxide (PbO₂) or lead tetroxide (Pb₃O₄), and the like). In one embodiment of the present invention, the lead-free glass frit contains tellurium oxide, bismuth oxide, selenium oxide and lithium oxide as the main components.
In a further preferred example of the present invention, the mixture of tellurium oxide, bismuth oxide, selenium oxide and lithium oxide comprises one or more metal oxides, such as zirconium oxide (ZrO₂), vanadium pentoxide (V₂O₅) silver oxide (Ag₂O), erbium oxide (Er₂O₃), tin oxide (SnO), magnesium oxide (MgO), neodymium oxide (Nd₂O₃), aluminum oxide (Al₂O₃), titanium dioxide (TiO₂) sodium oxide (Na₂O), potassium oxide (K₂O) phosphorus pentoxide (P₂O₅) molybdenum dioxide (MoO₂) manganese dioxide (MnO₂), nickel oxide (NiO), tungsten oxide (WO₃), samarium oxide (Sm₂O₃), germanium dioxide (GeO₂), zinc oxide (ZnO), indium oxide (In₂O₃), gallium oxide (Ga₂O₃), silicon dioxide (SiO₂) and ferric oxide (Fe₂O₃), etc. Hence, the "tellurium-bismuth-selenium-lithium-oxide" recited in the present invention also can include one or more metal elements or the oxides thereof, such as phosphorus (P), barium (Ba), sodium (Na), magnesium (Mg), zinc (Zn), calcium (Ca), strontium (Sr), tungsten (W), aluminum (Al), potassium (K), zirconium (Zr), vanadium (V), iron (Fe), indium (In), manganese (Mn), tin (Sn), nickel (Ni), antimony (Sb), silver (Ag), silicon (Si), erbium (Er), germanium (Ge), titanium (Ti), gallium (Ga), cerium (Ce), niobium (Nb), samarium (Sm) and lanthanum (La), etc. in an amount of 0.1 wt.% to 10 wt. % based on the lead-free glass frit.

In the present invention, the inorganic components comprising the solids of the conductive metal (a) and the lead-free glass frit (b) are mixed with the organic vehicle (c) to form a conductive paste, wherein the organic vehicle(c) could be in liquid form. Suitable organic vehicles can allow said inorganic components to be uniformly dispersed therein and have a proper viscosity to deliver said inorganic components to the surface of the antireflective coating by screen printing, stencil printing or the like. The conductive paste also must have good drying rate and excellent fire-through properties.

The organic vehicle is a solvent which is not subject to particular limitation and can be properly selected from conventional solvents for conductive pastes. Examples of solvents include alcohols (e.g., isopropyl alcohol), esters (e.g., propionate, dibutyl phthalate) and ethers (e.g., butyl carbitol) or the like or the mixture thereof. Preferably, the solvent is an ether having a boiling point of 120°C to 300°C. Most preferably, the solvent is butyl carbitol. The organic vehicle can further comprise volatile liquids to promote the rapid hardening after application of the conductive paste onto the semiconductor substrate.

In one preferred example of the present invention, the organic vehicle is a solution comprising a polymer and a solvent. Because the organic vehicle composed of a solvent and a dissolved polymer disperses the inorganic components comprising a conductive metal and a lead-free glass frit, a conductive paste having suitable viscosity can be easily prepared. After printing on the surface of the antireflective coating and drying, the polymer increases the adhesiveness and original strength of the conductive paste.

Examples of polymers include cellulose (e.g., ethyl cellulose), nitrocellulose, ethyl hydroxyethylcellulose, carboxymethylcellulose, hydroxypropylcellulose or other cellulose derivatives), poly(meth)acrylate resins of lower alcohols, phenolic resins (e.g., phenol resin), alkyd resins (e.g., ethylene glycol monoacetate) or the like or the mixtures thereof. Preferably, the polymer is cellulose. Most preferably, the polymer is ethyl cellulose.

In one preferred example of the present invention, the organic vehicle comprises ethyl cellulose dissolved in ethylene glycol butyl ether.

In another preferred example of the present invention, the organic vehicle comprises one or more functional additives. Examples of functional additives include viscosity modifiers, dispersing agents, thixotropic agents, wetting agents and/or optionally other conventional additives (for example, colorants, preservatives or oxidants),and etc. Functional additives are not subject to particular limitation as long as they do not adversely affect the technical effect of the present invention.

In the conductive paste of the present invention, the ratio of the inorganic compounds (including the conductive metal (a) and the lead-free glass frit (b)) to the organic vehicle is dependent on the desired viscosity of the conductive paste to be printed onto the antireflective coating. Generally, the conductive paste comprises inorganic components in amount of 70wt% to 95wt% and organic vehicle in an amount of 5wt% to 30wt%.

The conductive paste of the present invention is first printed on the antireflective coating as grid lines or other patterns wherein the printing step could be carried out by conventional methods, such as screen printing or stencil printing, etc. Then, the fire-through step is carried out at a oxygen-containing atmosphere (such as ambient air) by heating to a temperature of 850°C to 950°C for 0.05 to 5 minutes to remove the organic vehicle and fire the conductive metal, whereby the conductive paste after-firing is substantially free of any organic substances and the conductive paste after-firing penetrates through the antireflective coating to form contact with the semiconductor substrate and one or more antireflective coating(s) beneath. This fire-though step forms the electrical contact between the semiconductor substrate and the grid lines (or in other patterns) through metal contacts and therefore front electrodes are formed.

Another aspect of the present invention relates to an article, preferably for the manufacture of a semiconductor device, more preferably for the manufacture of a solar cell. In one example of the present invention, a semiconductor substrate is provided, wherein said semiconductor substrate includes substrates suitable for a semiconductor integrated chip, a glass substrate suitable for forming a solar cell or other substrates. One or more antireflective coating(s) can be applied onto the semiconductor substrate by conventional methods, such as chemical vapor deposition, plasma enhanced vapor deposition, etc. The conductive paste of the present invention comprising a lead-free glass frit is applied on the semiconductor substrate with antireflective coating(s). Subsequently, the abovementioned fire-through steps are performed to obtain the articles.

In one preferred example of the present invention, the semiconductor substrate comprises amorphous, polymorphous or monocrystalline silicon. In another preferred example of the present invention, the antireflective coating comprises silicon dioxide, titanium dioxide, silicon nitride or other conventional coatings.

Without intending to limit the present invention, the present invention is illustrated by means of the following examples.

### EXAMPLES

### Preparation of Conductive Pastes Containing Lead-free Glass Frit

An organic vehicle for conductive pastes is prepared by dissolving 5 to 25 grams of ethyl cellulose in 5 to 75 grams of ethylene glycol butyl ether and adding a small amount of a viscosity modifier, a dispersing agent, a thixotropic agent, a wetting agent therein. Then, a conductive paste is prepared by mixing and dispersing 80 to 99.5 grams of industrial grade silver powder, 0.1 to 10 grams of a lead-free glass frit (Table 1, Examples G1 to G15) and 10 to 30 grams of an organic vehicle in a three-roll mill.

Conductive pastes comprising lead-containing glass frits (Table 2, Comparative Examples PG1 to PG5) were prepared in the same manner.

**Table 1 Components of the Lead-free Glass Frit (TeO₂-Bi₂O₃-SeO₂-Li₂O) and the Weight Percentages thereof (Examples)**

| wt% | G1 | G2 | G3 | G4 | G5 | G6 | G7 | G8 | G9 | G10 | G11 | G12 | G13 | G14 | G15 |
|---|---|---|---|---|---|---|---|---|---|---|---|---|---|---|---|
| TeO₂ | 62.5 | 58.5 | 65.5 | 67 | 72 | 73.5 | 77 | 83.0 | 70 | 75 | 75.5 | 86.5 | 55.5 | 63.85 | 66.5 |
| Bi₂O₃ | 14 | 13.5 | 11 | 13.5 | 9 | 8.5 | 6.4 | 5.5 | 3 | 0.5 | 8 | 5 | 12 | 6.5 | 14.5 |
| SeO₂ | 8.5 | 3 | 4.5 | 5.5 | 8 | 5 | 10.6 | 6.5 | 0.5 | 1.5 | 3 | 2.5 | 14.5 | 1 | 1.5 |
| Li₂O | 9.5 | 14.5 | 5 | 5.5 | 11 | 7 | 6 | 1.5 | 3 | 0.3 | 3 | 6 | 3.5 | 2 | 14.5 |
| CaO | | | | 0.5 | | 1 | | | | 3 | | | | 1.65 | |
| SiO₂ | | | 0.5 | | | | | | 3 | | | | | | |
| Na₂O | | 5 | | 3 | | 2 | | 1.0 | 2 | 0.7 | | | 2 | | |
| ZnO | 3 | | 7 | | | 3 | | 1.0 | 5 | | | | 5 | 10 | |
| Al₂O3 | 1 | | 0.5 | | | | | | 5 | 5 | | | 2 | | 1 |
| MgO | 0.5 | | 2 | | | | | | | | | | 0.5 | | 1 |
| P₂O₅ | | | 2 | 2 | | | | 1.0 | 0.5 | 3 | 5 | | 2 | 3 | |
| Fe₂O₃ | | 0.5 | | 3 | | | | | | 3 | 1.5 | | 1.5 | 2 | |
| WO₃ | 1 | 5 | 2 | | | | | | 8 | 8 | 4 | | 1.5 | 10 | 1 |
| total (g) | 100 | 100 | 100 | 100 | 100 | 100 | 100 | 100 | 100 | 100 | 100 | 100 | 100 | 100 | 100 |

**Table 2 Components of the Lead-containing (PbO) Glass Frit and the Weight Percentages thereof (Comparative Examples)**

| wt % | PG1 | PG2 | PG3 | PG4 | PG5 |
|---|---|---|---|---|---|
| SiO₂ | 3 | 4 | 4 | | |
| PbO | 33 | 89 | 89 | 49.2 | 60 |
| B₂O₃ | | 4.5 | 4.5 | | |
| TeO₂ | 56 | | | 46.2 | 40 |
| ZnO | 2 | | 2.5 | 1 | |
| P₂O₅ | 2 | | | | |
| Bi₂O₃ | 3 | | | 2.6 | |
| Sb₂O₃ | | 2.5 | | | |
| TiO₂ | | | | 1 | |
| WO₃ | 1 | | | | |
| total (g) | 100 | 100 | 100 | 100 | 100 |

### Preparation of a Front Electrode of the Solar cell

A conductive paste comprising a lead-free glass frit (Examples G1 to G15) was applied onto the front side of a solar cell substrate by screen printing. The surfaces of the solar cell substrate had been previously treated with an antireflective coating (silicon mononitride) and the back electrode of the solar cell had been previously treated with an aluminum paste (GSMC company, Item No. A136). A screen printing step was carried out by drying at a temperature of 100°C to 250°C for 5 to 30 minutes after screen printing (condition varies with the type of the organic vehicle and the quantity weight of the printed materials).

A fire-through step was carried out for the dried conductive paste containing a lead-free glass frit at a firing temperature of 850°C to 950°C by means of an IR conveyer type furnace. After fire-through, both front side and back side of the solar cell substrate are formed with solid electrodes.

Solar cells with front electrodes comprising a lead-containing glass frit (Comparative Examples PG1 to PG5) were prepared in the same manner.

### Solar Cells Performance Test

The resultant solar cell was subjected to measurements of electrical characteristics using a solar performance testing device (Berger, Pulsed Solar Load PSL-SCD) under AM 1.5G solar light to determine the open circuit voltage (Uoc), unit: V), short-circuit current (Isc, unit: A), series resistance (Rs, unit: Ω), fill factor (FF, unit: %) and conversion efficiency (Ncell, unit: %), etc. The test results are shown in Tables 3 and 4 below.

**Table 3 Solar Cells Applied with Conductive Pastes Comprising Lead-free Glass Frits (Examples)**

| Glasses | Uoc | Isc | Rs | FF | Ncell (%) |
|---|---|---|---|---|---|
| G1 | 0.6230 | 8.702 | 0.00288 | 78.1 | 17.39 |
| G2 | 0.6240 | 8.723 | 0.00321 | 77.7 | 17.38 |
| G3 | 0.6230 | 8.705 | 0.00268 | 78.3 | 17.44 |
| G4 | 0.6222 | 8.717 | 0.00268 | 78.3 | 17.45 |
| G5 | 0.6225 | 8.718 | 0.00279 | 78.1 | 17.41 |
| G6 | 0.6234 | 8.714 | 0.00275 | 78.2 | 17.45 |
| G7 | 0.6236 | 8.714 | 0.00275 | 78.3 | 17.47 |
| G8 | 0.6238 | 8.726 | 0.00276 | 78.3 | 17.52 |
| G9 | 0.6235 | 8.725 | 0.00312 | 77.8 | 17.39 |
| G10 | 0.6226 | 8.714 | 0.00280 | 78.2 | 17.44 |
| G11 | 0.6221 | 8.724 | 0.00294 | 78.1 | 17.42 |
| G12 | 0.6226 | 8.720 | 0.00291 | 78.1 | 17.42 |
| G13 | 0.6227 | 8.708 | 0.00275 | 78.2 | 17.42 |
| G14 | 0.6234 | 8.719 | 0.00274 | 78.3 | 17.48 |
| G15 | 0.6231 | 8.706 | 0.00281 | 78.2 | 17.43 |

**Table 4 Solar Cells Applied with Conductive Pastes Comprising Lead-containing Glass Frits (Comparative Examples)**

| Glass | Uoc | Isc | Rs | FF | Ncell (%) |
|---|---|---|---|---|---|
| PG1 | 0.6241 | 8.688 | 0.00284 | 78.1 | 17.41 |
| PG2 | 0.6199 | 9.040 | 0.00920 | 70.4 | 16.56 |
| PG3 | 0.6213 | 9.080 | 0.00760 | 72.7 | 17.23 |
| PG4 | 0.6165 | 7.440 | 0.05910 | 98.2 | 6.00 |
| PG5 | 0.6129 | 8.680 | 0.00785 | 70.3 | 15.37 |

From the performance test data in Tables 3 and 4, it can be seen that all the conductive pastes of the present invention comprising lead-free glass frits containing tellurium-bismuth-selenium-lithium-oxide (Examples G1 to G15) have a conversion efficiency comparable to part of the conductive pastes comprising lead-containing glass frits (Comparative Examples PG1, PG3). All the conductive pastes of the present invention comprising lead-free glass frits containing tellurium-bismuth-selenium-lithium-oxide (Examples G1 to G15) even have a better and unexpected conversion efficiency as compared to part of the conductive pastes comprising lead-containing glass frits (Comparative Examples PG2, PG4, PG5).

Hence, the present invention provides an environmentally friendly, lead-free conductive paste which can be fired at a lower temperature and has excellent efficacy comparable to conventional the lead-containing conductive paste.

The above preferred examples are only used to illustrate the technical features of the present invention and the technical effects thereof. The technical content of said examples can still be practiced by substantially equivalent combination, modifications, replacements and/or conversions. Accordingly, the protection scope of the present invention is based on the scope of the inventions defined by the appended claims.

## Claims

1. A conductive paste comprising:
(a) 85% to 99.5% by weight of a conductive metal, based on the weight of solids;
(b) 0.5% to 15% by weight of a lead-free glass frit containing tellurium-bismuth-selenium-lithium-oxide, based on the weight of solids; and
(c) an organic vehicle;
wherein the weight of solids is the total weight of the conductive metal (a) and the lead-free glass frit (b), and wherein the tellurium oxide is present in an amount of 55 wt.% to 90 wt.%, the selenium oxide is present in an amount of 0.1 wt.% to 15 wt.% in the lead-free glass frit, the bismuth oxide is present in an amount of 0.1 wt.% to 15 wt.%, and the lithium oxide is present in an amount of 0.1 wt.% to 15 wt.% in the lead-free glass frit.

2. The conductive paste according to claim 1, wherein the conductive paste comprise silver powder.

3. The conductive paste according to claim 1, which further comprises one or more metal oxides selected from the group consisting of zirconium oxide (ZrO₂), vanadium pentoxide (V₂O₅) silver oxide (Ag₂O), erbium oxide (Er₂O₃), tin oxide (SnO), magnesium oxide (MgO), neodymium oxide (Nd₂O₃), aluminum oxide (Al₂O₃), titanium dioxide (TiO₂) sodium oxide (Na₂O),potassium oxide (K₂O) phosphorus pentoxide (P₂O₅) molybdenum dioxide (MoO₂)manganese dioxide (MnO₂), nickel oxide (NiO), tungsten oxide (WO₃), samarium oxide (Sm₂O₃), germanium dioxide (GeO₂), zinc oxide (ZnO), indium oxide (In₂O₃), gallium oxide (Ga₂O₃), silicon dioxide (SiO₂) and ferric oxide (Fe₂O₃).

4. The conductive paste according to claim 1, wherein the lead-free glass frit further comprises one or more metals selected from the following group or the oxide thereof: phosphorus (P), barium (Ba), sodium (Na), magnesium (Mg), zinc (Zn), calcium (Ca), strontium (Sr), tungsten (W), aluminum (Al), potassium (K), zirconium (Zr), vanadium (V), iron (Fe), indium (In), manganese (Mn), tin (Sn), nickel (Ni), antimony (Sb), silver (Ag), silicon (Si), erbium (Er), germanium (Ge), titanium (Ti), gallium (Ga), cerium (Ce), niobium (Nb), samarium (Sm) and lanthanum (La) in an amount of 0.1 wt.% to 10 wt. % based on the lead-free glass frit.

5. The conductive paste according to claim 1, wherein the organic vehicle is a solution comprising a polymer and a solvent.

6. The conductive paste according to claim 1, wherein the organic vehicle further comprises one or more functional additives selected from the group consisting of a viscosity modifier, a dispersing agent, a thixotropic agent and a wetting agent.

7. An article comprising a semiconductor substrate and a conductive paste according to any one of claims 1-6 applied onto the semiconductor substrate.

8. The article according to claim 7, which further comprises one or more antireflective coatings applied onto the semiconductor substrate; and
wherein the conductive paste contacts the antireflective coating(s) and has electrical contact with the semiconductor substrate.

9. The article according to claim 8, which is a semiconductor device.

10. The article according to claim 9, wherein the semiconductor device is a solar cell.

## Patentansprüche

1. Eine leitfähige Paste, umfassend:
(a) 85 Gew.-% bis 99,5 Gew.-% eines leitfähigen Metalls, basierend auf dem Gewicht der Feststoffe;
(b) 0,5 Gew.-% bis 15 Gew.-% einer bleifreien Glasfritte, enthaltend Tellur-Bismut-Selen-Lithiumoxid, basierend auf dem Gewicht der Feststoffe; und
(c) ein organisches Medium;
wobei das Gewicht der Feststoffe das Gesamtgewicht des leitfähigen Metalls (a) und der bleifreien Glasfritte (b) ist, und wobei das Telluroxid in einer Menge von 55 Gew.-% bis 90 Gew.-% vorliegt, das Selenoxid in einer Menge von 0,1 Gew.-% bis 15 Gew.-% in der bleifreien Glasfritte vorliegt, das Bismutoxid in einer Menge von 0,1 Gew.-% bis 15 Gew.-% vorliegt, und das Lithiumoxid in einer Menge von 0,1 Gew.-% bis 15 Gew.-% in der bleifreien Glasfritte vorliegt.

2. Die leitfähige Paste gemäß Anspruch 1, wobei die leitfähige Paste Silberpulver umfasst.

3. Die leitfähige Paste gemäß Anspruch 1, welche ferner ein oder mehrere Metalloxide umfasst, ausgewählt aus der Gruppe bestehend aus Zirkoniumoxid (ZrO₂), Vanadiumpentoxid (V₂O₅) Silberoxid (Ag₂O), Erbiumoxid (Er₂O₃), Zinnoxid (SnO), Magnesiumoxid (MgO), Neodymoxid (Nd₂O₃), Aluminiumoxid (Al₂O3), Titandioxid (TiO₂) Natriumoxid (Na₂O),Kaliumoxid (K₂O) Phosphorpentoxid (P₂O₅) Molybdändioxid (MoO₂)Mangandioxid (MnO₂), Nickeloxid (NiO), Wolframoxid (WO₃), Samariumoxid (Sm₂O₃), Germaniumdioxid (GeO₂), Zinkoxid (ZnO), Indiumoxid (In₂O₃), Galliumoxid (Ga₂O₃), Siliciumdioxid (SiO₂) und Eisenoxid (Fe₂O₃).

4. Die leitfähige Paste gemäß Anspruch 1, wobei die bleifreie Glasfritte weiter ein oder mehrere Metalle umfasst, ausgewählt aus der folgenden Gruppe oder den Oxiden davon: Phosphor (P), Barium (Ba), Natrium (Na), Magnesium (Mg), Zink (Zn), Calcium (Ca), Strontium (Sr), Wolfram (W), Aluminium (Al), Kalium (K), Zirkonium (Zr), Vanadium (V), Eisen (Fe), Indium (In), Mangan (Mn), Zinn (Sn), Nickel (Ni), Antimon (Sb), Silber (Ag), Silicium (Si), Erbium (Er), Germanium (Ge), Titan (Ti), Gallium (Ga), Cer (Ce), Niob (Nb), Samarium (Sm) und Lanthan (La) in einer Menge von 0,1 Gew.-% bis 10 Gew.-%, basierend auf der bleifreien Glasfritte.

5. Die leitfähige Paste gemäß Anspruch 1, wobei das organische Medium eine Lösung ist, die ein Polymer und ein Lösungsmittel umfasst.

6. Die leitfähige Paste gemäß Anspruch 1, wobei das organische Medium ferner ein oder mehrere funktionale Additive umfasst, ausgewählt aus der Gruppe, bestehend aus einem Viskositäts-Modifizierer, einem Dispersionsmittel, einem thixotropen Mittel und einem Benetzungsmittel.

7. Ein Gegenstand umfasst ein Halbleitersubstrat und eine leitfähige Paste, gemäß einem der Ansprüche 1-6, aufgetragen auf das Halbleitersubstrat.

8. Der Gegenstand gemäß Anspruch 7, welcher ferner ein oder mehrere Anti-Reflex-Beschichtungen, aufgetragen auf das Halbleitersubstrat, umfasst; und
wobei die leitfähige Paste die Anti-Reflex-Beschichtung(en) berührt und elektrischen Kontakt mit dem Halbleitersubstrat hat.

9. Der Gegenstand gemäß Anspruch 8, der eine Halbleitervorrichtung ist.

10. Der Gegenstand gemäß Anspruch 9, wobei die Halbleitervorrichtung eine Solarzelle ist.

## Revendications

1. Pâte conductrice comprenant :
(a) 85 % à 99,5 % en poids d'un métal conducteur, sur la base du poids de matières solides ;
(b) 0,5 % à 15 % en poids d'une fritte de verre sans plomb contenant un oxyde de tellure-bismuth-sélénium-lithium, sur la base du poids de matières solides ; et
(c) un véhicule organique ;
dans laquelle le poids de matières solides est le poids total du métal conducteur (a) et la fritte de verre sans plomb (b), et dans laquelle l'oxyde de tellure est présent en une quantité de 55 % en poids à 90 % en poids, l'oxyde de sélénium est présent en une quantité de 0,1 % en poids à 15 % en poids dans la fritte de verre sans plomb, l'oxyde de bismuth est présent en une quantité de 0,1 % en poids à 15 % en poids, et l'oxyde de lithium est présent en une quantité de 0,1 % en poids à 15 % en poids dans la fritte de verre sans plomb.

2. Pâte conductrice selon la revendication 1, la pâte conductrice comprenant de la poudre d'argent.

3. Pâte conductrice selon la revendication 1, qui comprend en outre un ou plusieurs oxydes métalliques choisis dans le groupe constitué de l'oxyde de zirconium (ZrO₂), le pentoxyde de vanadium (V₂O₅) l'oxyde d'argent (Ag₂O), l'oxyde d'erbium (Er₂O₃), l'oxyde d'étain (SnO), l'oxyde de magnésium (MgO), l'oxyde de néodyme (Nd₂O₃), l'oxyde d'aluminium (Al₂O₃), le dioxyde de titane (TiO₂) l'oxyde de sodium (Na₂O),l'oxyde de potassium (K₂O) le pentoxyde de phosphore (P₂O₅) le dioxyde de molybdène (MoO₂)le dioxyde de manganèse (MnO₂), l'oxyde de nickel (NiO), l'oxyde de tungstène (WO₃), l'oxyde de samarium (Sm₂O₃), le dioxyde de germanium (GeO₂), l'oxyde de zinc (ZnO), l'oxyde d'indium (In₂O₃), l'oxyde de gallium (Ga₂O₃), le dioxyde de silicium (SiO₂) et l'oxyde ferrique (Fe₂O₃).

4. Pâte conductrice selon la revendication 1, dans laquelle la fritte de verre sans plomb comprend en outre un ou plusieurs métaux choisis dans le groupe suivant ou l'oxyde de ceux-ci : phosphore (P), baryum (Ba), sodium (Na), magnésium (Mg), zinc (Zn), calcium (Ca), strontium (Sr), tungstène (W), aluminium (Al), potassium (K), zirconium (Zr), vanadium (V), fer (Fe), indium (In), manganèse (Mn), étain (Sn), nickel (Ni), antimoine (Sb), argent (Ag), silicium (Si), erbium (Er), germanium (Ge), titane (Ti), gallium (Ga), cérium (Ce), niobium (Nb), samarium (Sm) et lanthane (La) en une quantité de 0,1 % en poids à 10 % en poids sur la base de la fritte de verre sans plomb.

5. Pâte conductrice selon la revendication 1, dans laquelle le véhicule organique est une solution comprenant un polymère et un solvant.

6. Pâte conductrice selon la revendication 1, dans laquelle le véhicule organique comprend en outre un ou plusieurs additifs fonctionnels choisis dans le groupe constitué d'un modificateur de viscosité, un agent dispersant, un agent thixotrope et un agent mouillant.

7. Article comprenant un substrat semi-conducteur et une pâte conductrice selon l'une quelconque des revendications 1 à 6 appliquée sur le substrat semi-conducteur.

8. Article selon la revendication 7, qui comprend en outre un ou plusieurs revêtements antireflet appliqués sur le substrat semi-conducteur ; et
dans lequel la pâte conductrice vient en contact avec le(s) revêtement(s) antireflet et a un contact électrique avec le substrat semi-conducteur.

9. Article selon la revendication 8, qui est un dispositif à semi-conducteur.

10. Article selon la revendication 9, dans lequel le dispositif à semi-conducteur est une cellule solaire.
